# EUROPEAN PATENT APPLICATION

(11) **EP 4 851 645 A1**
(43) Date of publication of application: **09.12.2026**
(21) Application number: 25880303.0
(22) Date of filing: 10.10.2025
(51) Int. Cl.: G01R 31/367, G01R 31/396, G06N 3/047, B60L 58/10

(54) **APPARATUS AND METHOD FOR DIAGNOSING BATTERY**

(30) Priority: 14.10.2024 KR 20240139422
(71) Applicant: LG Energy Solution, Ltd., Seoul 07335 (KR)
(72) Inventor: YOO, Ji-Won, Daejeon 34122 (KR)
(74) Representative: Goddar, Heinz J.
(86) International application number: PCT/KR2025/015975
(87) International publication number: WO 2026/084374

(57) **Abstract**

A battery diagnosis apparatus according to an embodiment of the present disclosure includes a data obtaining unit configured to obtain diagnosis data including at least one of battery information of a target battery and driving information of a vehicle including the target battery for a predetermined period from a diagnosis reference time point; and a control unit configured to set a threshold value based on reference data corresponding to the predetermined period and a preset model, calculate a diagnosis value based on the diagnosis data and the model, and diagnose a state of the target battery based on the threshold value and the diagnosis value.

## Description

### TECHNICAL FIELD

This application is based on and claims priority from Korean Patent Application No. 10-2024-0139422, filed on October 14, 2024, with the Korean Intellectual Property Office, the disclosure of which is incorporated herein in its entirety by reference.

The present disclosure relates to a battery diagnosis apparatus and method capable of predicting and diagnosing a future state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

While much research is being conducted on these batteries to increase capacity and density, improving their lifespan and safety is also crucial. To enhance battery safety, technology is required to accurately diagnose the state of a battery.

### DISCLOSURE

### Technical Problem

The present disclosure is designed to solve the problems of the related art, and therefore the present disclosure is directed to providing a battery diagnosis apparatus and method capable of predicting and diagnosing a future state of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery diagnosis apparatus according to one aspect of the present disclosure may comprise: a data obtaining unit configured to obtain diagnosis data including at least one of battery information of a target battery and driving information of a vehicle including the target battery for a predetermined period from a diagnosis reference time point; and a control unit configured to set a threshold value based on reference data corresponding to the predetermined period and a preset model, calculate a diagnosis value based on the diagnosis data and the model, and diagnose a state of the target battery based on the threshold value and the diagnosis value.

The control unit may be configured to diagnose the state of the target battery at a time point after the predetermined period from the diagnosis reference time point, based on the threshold value and the diagnosis value.

The control unit may be configured to compare the threshold value with the diagnosis value and diagnose the state of the target battery based on the comparison result.

The control unit may be configured to calculate an error ratio of the reference data using the model, calculate a combined error based on the calculated error ratio, and set the calculated combined error as the threshold value.

The reference data may be provided in plurality.

The control unit may be configured to input a plurality of reference data into the model to calculate a combined error, and set the calculated combined error as the threshold value.

The control unit may be configured to calculate an average error rate of the plurality of reference data using the model and calculate the combined error based on the calculated average error rate.

The control unit may be configured to calculate an error ratio of the diagnosis data using the model, calculate a combined error based on the calculated error ratio, and set the calculated combined error as the diagnosis value.

The control unit may be configured to set data corresponding to the predetermined period among a plurality of preset data as the reference data.

The control unit may be configured to determine data corresponding to a diagnosis item of the target battery among the plurality of data and set the reference data among the determined data.

The model may be configured as a model based on a recurrent neural network (RNN).

A battery pack according to another aspect of the present disclosure comprises the battery diagnosis apparatus according to one aspect of the present disclosure.

A vehicle according to still another aspect of the present disclosure comprises the battery diagnosis apparatus according to one aspect of the present disclosure.

A server according to still another aspect of the present disclosure comprises the battery diagnosis apparatus according to one aspect of the present disclosure.

A battery diagnosis method according to still another aspect of the present disclosure may comprise: a data obtaining step of obtaining diagnosis data including at least one of battery information of a target battery and driving information of a vehicle including the target battery for a predetermined period from a diagnosis reference time point; a threshold value setting step of setting a threshold value based on reference data corresponding to the predetermined period and a preset model; a diagnosis value setting step of calculating a diagnosis value based on the diagnosis data and the model; and a diagnosis step of diagnosing a state of the target battery based on the threshold value and the diagnosis value.

A computer-readable recording medium according to still another aspect of the present disclosure may store a computer program for executing a battery diagnosis method, comprising: a data obtaining step of obtaining diagnosis data including at least one of battery information of a target battery and driving information of a vehicle including the target battery for a predetermined period from a diagnosis reference time point; a threshold value setting step of setting a threshold value based on reference data corresponding to the predetermined period and a preset model; a diagnosis value setting step of calculating a diagnosis value based on the diagnosis data and the model; and a diagnosis step of diagnosing a state of the target battery based on the threshold value and the diagnosis value.

### Advantageous Effects

According to one aspect of the present disclosure, the battery diagnosis apparatus has the advantage of being able to predict and diagnose the future state of the target battery after a predetermined period.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating a battery diagnosis apparatus according to an embodiment of the present disclosure.
FIG. 2 is a diagram schematically illustrating a temporal error of reference data according to an embodiment of the present disclosure.
FIG. 3 is a diagram schematically illustrating an error ratio of reference data according to an embodiment of the present disclosure.
FIG. 4 is a diagram schematically illustrating an error ratio of diagnosis data according to an embodiment of the present disclosure.
FIG. 5 is a diagram schematically illustrating an average error rate of reference data according to an embodiment of the present disclosure.
FIG. 6 is a drawing schematically illustrating a battery pack according to another embodiment of the present disclosure.
FIG. 7 is a drawing schematically illustrating a vehicle according to still another embodiment of the present disclosure.
FIG. 8 is a drawing schematically illustrating a server according to still another embodiment of the present disclosure.
FIG. 9 is a drawing schematically illustrating a battery diagnosis method according to still another embodiment of the present disclosure.

### BEST MODE

Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a most preferred example for the purpose of illustrations only, not intended to limit the scope of the disclosure, so it should be understood that other equivalents and modifications could be made thereto without departing from the scope of the disclosure.

In addition, when explaining the present disclosure, if it is judged that the detailed description of the related known structure or function may obscure the main point of the present disclosure, the detailed description will be omitted.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the attached drawings.

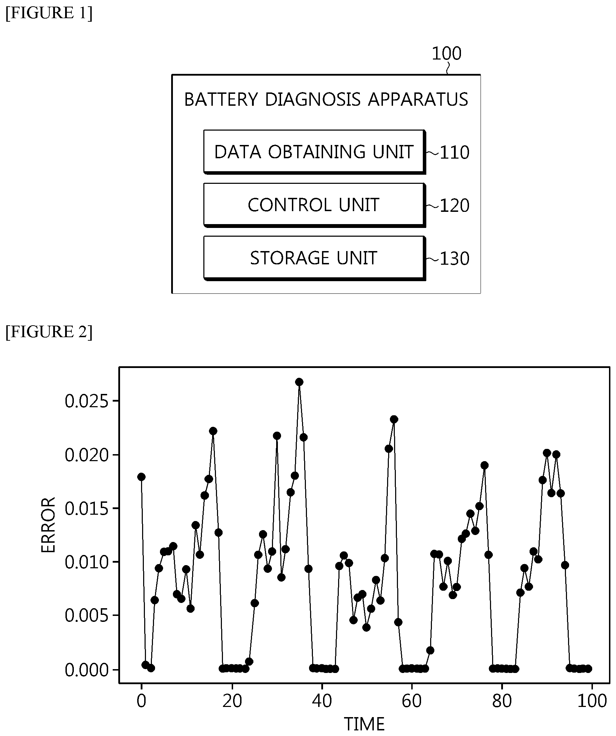

FIG. 1 is a diagram schematically illustrating a battery diagnosis apparatus 100 according to an embodiment of the present disclosure.

Referring to FIG. 1, a battery diagnosis apparatus 100 may include a data obtaining unit 110 and a control unit 120.

The data obtaining unit 110 may be configured to obtain diagnosis data including at least one of battery information of a target battery and driving information of a vehicle including the target battery for a predetermined period from a diagnosis reference time point.

Here, the battery refers to an independent cell that has a negative electrode terminal and a positive electrode terminal and is physically separable. As an example, a lithium-ion cell or a lithium polymer cell may be considered a battery. Additionally, the type of battery may be cylindrical type, prismatic type, or pouch type. Additionally, a battery may also mean a battery bank, a battery module, or a battery pack including a plurality of cells connected in series and/or parallel.

Specifically, the data obtaining unit 110 may obtain battery information regarding the voltage and current of the battery for a predetermined period from the outside. For example, if the battery is included in a vehicle, the data obtaining unit 110 may obtain battery information regarding the temporal voltage and temporal current of the battery measured while the vehicle is being driven for a predetermined period.

For example, the data obtaining unit 110 may obtain battery information by directly measuring the voltage and current of the battery. As another example, the data obtaining unit 110 may also obtain battery information by receiving battery information from an external source that is connected for communication.

In addition, the data obtaining unit 110 may obtain driving information regarding the speed of a vehicle including a battery from an external source. For example, the data obtaining unit 110 may obtain driving information regarding the temporal speed measured while the vehicle is being driven for a predetermined period.

The control unit 120 may be configured to set a threshold value based on reference data corresponding to a predetermined period and a preset model.

Specifically, the control unit 120 may be configured to set data corresponding to a predetermined period among a plurality of preset data as the reference data.

More specifically, the control unit 120 may set the reference data to correspond to the period of diagnosis data in order to compare the diagnosis data and the reference data under the same period conditions. For example, if the diagnosis data corresponds to the first period, the control unit 120 may set data corresponding to the first period among a plurality of preset data as the reference data.

Preferably, the reference data is data that serves as a standard for diagnosing the state of the battery. Therefore, the reference data may include previous data for a predetermined period based on the time point at which an abnormality has occurred.

For example, assume that an abnormality occurs at time point t1 and the predetermined period is △t. The control unit 120 may set data from time point t1-△t+1 to time point t1 among a plurality of data as the reference data.

As a more specific example, assume that an abnormality occurs at 100 time point and the predetermined period is 60. The control unit 120 may set data from time point 41 to time point 100 as the reference data.

Next, the control unit 120 may be configured to calculate the error ratio of the reference data using the model.

First, the control unit 120 may input the reference data into the model to calculate the error ratio of the reference data, and obtain data on the error of the reference data per unit time from the model. Here, the model may be preset to output the error of the input data per unit time. For example, the model may divide the input data into unit times, compare each divided data with pre-trained data, and output the error for each unit time.

FIG. 2 is a diagram schematically illustrating a temporal error of reference data according to an embodiment of the present disclosure. For example, the temporal error of FIG. 2 may be expressed as an X-Y graph in which the X-axis is set to time and the Y-axis is set to error. In the embodiment of FIG. 2, the predetermined period is 0 to 100. Accordingly, the control unit 120 may obtain data regarding the temporal error of the reference data corresponding to time 0 to 100.

Next, the control unit 120 may be configured to calculate an error ratio based on the temporal error of the reference data. Specifically, the control unit 120 may calculate the error ratio by considering the frequency of each error during a predetermined period.

For example, assume that a predetermined period is divided into a total of 100 unit times, and the error corresponding to 50 unit times is 0.025, and the error corresponding to 10 unit times is 0.01. In this case, the ratio of error 0.025 is 0.5, and the ratio of error 0.01 is 0.1. In this way, the control unit 120 may calculate the error ratio based on the temporal error of the reference data.

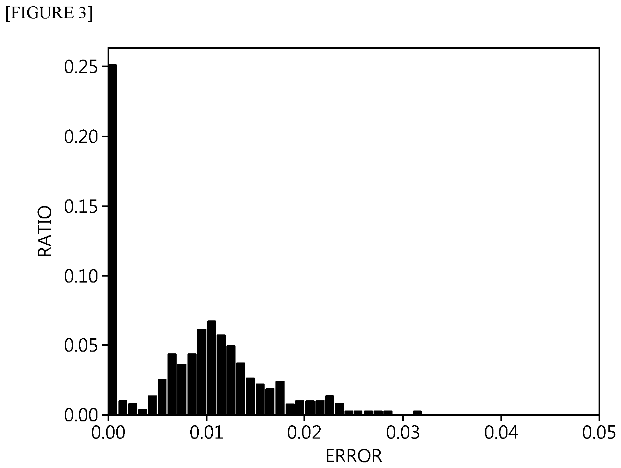

FIG. 3 is a diagram schematically illustrating an error ratio of reference data according to an embodiment of the present disclosure. In the embodiment of FIG. 3, the error ratio may be expressed as an X-Y graph in which the X-axis is set to error and the Y-axis is set to ratio. In the embodiment of FIG. 3, the sum of the error ratios is 1. The control unit 120 may calculate a ratio for each error based on the temporal error of FIG. 2.

The control unit 120 may be configured to calculate the combined error based on the calculated error ratio.

Specifically, the control unit 120 may calculate the combined error representing the reference data based on the error ratio. For example, the combined error is a weighted error calculated based on the error ratio. The control unit 120 may calculate the weighted error by multiplying each of the plurality of errors by the corresponding ratio and adding all of the multiplied values. For example, the control unit 120 may calculate the combined error based on the following formula. [Formula 1] ${E}_{\left(t\right)} = {\sum }_{i = min}^{max} {E}_{i} \times {P}_{i}$

Here, Eᵢ is the error corresponding to unit time i, Pᵢ is the rate corresponding to unit time i. Eₜ is the combined error (e.g., weighted error) for all unit times.

In addition, the control unit 120 may be configured to set the calculated combined error as a threshold value. Specifically, the control unit 120 may set the threshold value from the reference data by considering a predetermined period corresponding to the diagnosis data. That is, since the threshold value is determined according to the predetermined period corresponding to the diagnosis data, the control unit 120 may adaptively set a threshold value suitable for the predetermined period.

The control unit 120 may be configured to calculate a diagnosis value based on the diagnosis data and the model. Here, since the diagnosis data corresponds to a predetermined period, the control unit 120 may calculate the diagnosis value from the diagnosis data obtained by the data obtaining unit 110.

Specifically, the control unit 120 may be configured to calculate an error ratio of the diagnosis data using the model. That is, the control unit 120 may calculate an error ratio of the diagnosis data using the model in the same manner as calculating an error ratio of the reference data by inputting the reference data into the model. For example, the control unit 120 may input the diagnosis data into the model and obtain data on unit time errors of the diagnosis data from the model. In addition, the control unit 120 may calculate an error ratio based on the temporal error of the diagnosis data. For example, the control unit 120 may calculate an error ratio by considering the frequency of each error during a predetermined period.

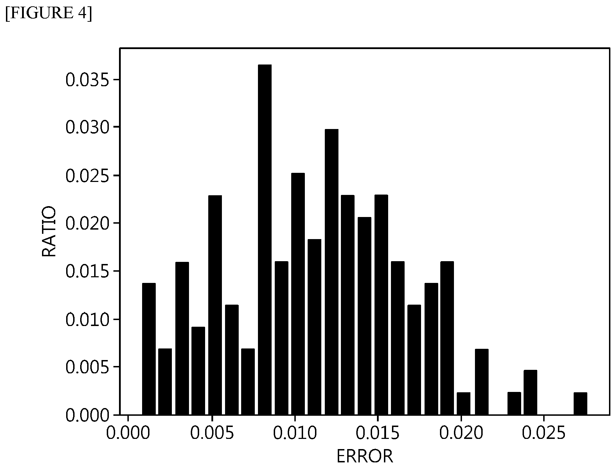

FIG. 4 is a diagram schematically illustrating an error ratio of diagnosis data according to an embodiment of the present disclosure. In the embodiment of FIG. 4, the error ratio may also be expressed as an X-Y graph in which the X-axis is set as an error and the Y-axis is set as a ratio. In the embodiment of FIG. 4, the total sum of the error ratios is 1.

The control unit 120 may be configured to calculate the combined error based on the calculated error ratio.

Specifically, the control unit 120 may calculate a combined error representing the diagnosis data based on an error ratio. For example, the combined error is a weighted error calculated based on the error ratio. The control unit 120 may calculate a combined error for a plurality of errors using Formula 1.

In addition, the control unit 120 may be configured to set the calculated combined error as a diagnosis value. Specifically, since the diagnosis value and the threshold value calculated by control unit 120 are all values corresponding to a predetermined period, they are values with common temporal consistency.

The control unit 120 may be configured to diagnose the state of the target battery based on the threshold value and the diagnosis value.

Specifically, the control unit 120 may be configured to compare the threshold value with the diagnosis value and diagnose the state of the target battery based on the comparison result. The control unit 120 may compare the magnitudes of the threshold value and the diagnosis value and diagnose the state of the battery as a normal state or an abnormal state based on the comparison result. For example, if the diagnosis value is less than the threshold value, the control unit 120 may diagnose the state of the battery as a normal state. As another example, if the diagnosis value is greater than or equal to the threshold value, the control unit 120 may diagnose the state of the battery as an abnormal state.

Preferably, the control unit 120 may be configured to diagnose the state of the target battery at a time point after a predetermined period from the diagnosis reference time point based on the threshold value and the diagnosis value. That is, the control unit 120 may predict and diagnose the future state of the battery based on the comparison result between the threshold value and the diagnosis value.

Here, the diagnosis reference time point refers to the most recent time point corresponding to the diagnosis data. In other words, the diagnosis data refers to data from the diagnosis reference time point to a time point before a predetermined period.

Specifically, the threshold value is set based on the reference data for a predetermined period from the time point at which the abnormality has occurred, and the diagnosis value is set based on the diagnosis data for a predetermined period from the diagnosis reference time point. Therefore, the battery diagnosis apparatus 100 has the advantage of being able to predict and diagnose the future state of the target battery after a predetermined period by using the time indicator called the predetermined period.

Meanwhile, the data obtaining unit 110 and/or the control unit 120 included in the battery diagnosis apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the data obtaining unit 110 and/or the control unit 120 may be implemented as a set of program modules. At this time, the program module may be stored in the memory and executed by the data obtaining unit 110 and/or the control unit 120. The memory may be inside or outside the data obtaining unit 110 and/or the control unit 120 and may be connected to the data obtaining unit 110 and/or the control unit 120 by various well-known means.

In addition, the battery diagnosis apparatus 100 may further include a storage unit 130. The storage unit 130 may store data necessary for operation and function of each component of the battery diagnosis apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by each component of the battery diagnosis apparatus 100 are defined.

Meanwhile, the model may be configured as a model based on a recurrent neural network (RNN). Here, RNN is a model suitable for processing time-series data or sequential data, and is a model that adopts a structure that sequentially processes data and memorizes and learns information from previous stages. Representatively, RNN-based models include LSTM (Long Short-Term Memory) and GRU (Gated Recurrent Unit). In addition, RNN is a model that may track changes over time or learn patterns by dividing time-series data into regular intervals according to chronological order. For example, RNN may divide time-series data into unit times (e.g., timesteps) and analyze the characteristics of each unit time.

Specifically, the model may be an RNN-based time-series encoder-decoder model. The encoder-decoder structure is a model structure that extracts features by encoding (compressing) and then decoding (restoring) data. Models that adopt the encoder-decoder structure include Seq2Seq (Sequence to Sequence) and autoencoder.

For example, the battery diagnosis apparatus 100 may utilize an LSTM autoencoder model. The LSTM autoencoder is a model that learns data characteristics through the process of efficiently encoding and decoding input data based on an LSTM network. Therefore, the battery diagnosis apparatus 100 may calculate the error of the diagnosis data and the reference data per unit time using the LSTM autoencoder, and calculate the threshold value and the diagnosis value by considering the calculated error rate.

In one embodiment, the reference data may be provided in plurality. For example, if a plurality of reference batteries are provided as the basis for the reference data, each of the data corresponding to the plurality of reference batteries may be set as the reference data.

The control unit 120 may calculate the combined error by inputting a plurality of reference data into the model.

Specifically, the control unit 120 may be configured to calculate the average error rate of a plurality of reference data using the model. First, the control unit 120 may input each of the plurality of reference data into the model and calculate the error of each of the plurality of reference data per unit time. Then, the control unit 120 may calculate the error ratio of each of the plurality of reference data by considering the calculated error per unit time. Finally, the control unit 120 may calculate the average ratio for each error.

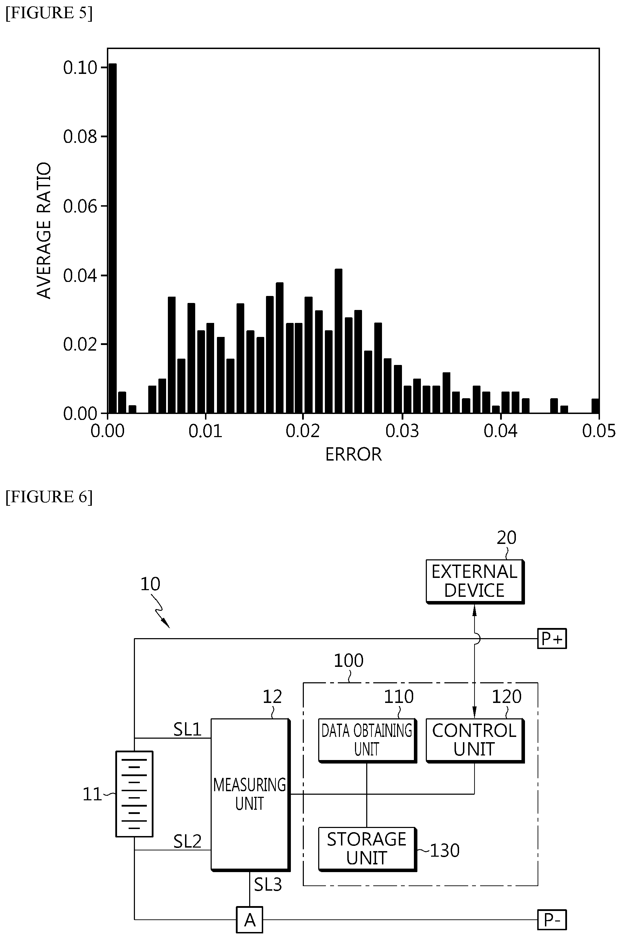

FIG. 5 is a diagram schematically illustrating an average error rate of reference data according to an embodiment of the present disclosure. In the embodiment of FIG. 5, the average error rate may be expressed as an X-Y graph in which the X-axis is set to error and the Y-axis is set to the average rate. For example, when n reference data are provided, the average rate of error 0.00 for the n reference data is approximately 0.1.

In addition, the control unit 120 may be configured to calculate the combined error based on the calculated average error rate.

Specifically, the control unit 120 may calculate a combined error representing the plurality of reference data based on the average error rate. For example, the combined error is a weighted error calculated based on the average error rate. The control unit 120 may calculate the combined error for the plurality of errors using Formula 1. For example, the average rate may be substituted into Pᵢ, which represents the rate corresponding to unit time i in Formula 1, to calculate the combined error based on the average error rate.

The control unit 120 may be configured to set the calculated combined error as a threshold value. That is, the control unit 120 may set a threshold value that serves as a criterion for diagnosing the state of the battery based on the plurality of reference data.

The battery diagnosis apparatus 100 according to an embodiment of the present disclosure may diagnose the state of a target battery by comprehensively considering the plurality of reference data to set a threshold value and comparing the set threshold value with the diagnosis value of the target battery. In other words, since the threshold value for the plurality of reference data are considered according to the battery diagnosis apparatus 100, the state of the battery may be diagnosed more accurately.

The control unit 120 may be configured to determine data corresponding to a diagnosis item of a target battery among a plurality of data.

For example, the diagnosis item may be set to various items such as an available lithium loss, a positive electrode capacity loss, a negative electrode capacity loss, a battery capacity loss, an insulation breakdown, a short circuit, an open circuit, and a low voltage. The control unit 120 may determine a diagnosis item to be diagnosed among several diagnosis items, and determine data corresponding to the determined diagnosis item among the plurality of data.

As a specific example, assume that the diagnosis item is an available lithium loss. The control unit 120 may select only the data corresponding to the available lithium loss among the plurality of data.

The control unit 120 may be configured to set the reference data among the determined data.

Specifically, the control unit 120 may specify a time point at which the available lithium loss has occurred in each determined data, extract only data before a predetermined period from the specified time point, and set the extracted data as the reference data.

Preferably, in order to maintain temporal consistency between the diagnosis data and the reference data, the control unit 120 may not set any data that does not exist before a predetermined period from a specific time point among the determined data as the reference data.

For example, in the previous embodiment, it is assumed that the predetermined period is set to 100. In data where the time point at which the available lithium loss has occurred is less than 100, there is no data prior to the predetermined period from the time point at which the available lithium loss has occurred. Therefore, the control unit 120 may not set such data as the reference data.

Since the battery diagnosis apparatus 100 selects reference data based on a diagnosis item and a predetermined period among a plurality of data, it has the advantage of being able to more accurately predict and diagnose the state of the battery.

The battery diagnosis apparatus 100 according to the present disclosure may be applied to a battery management system (BMS). That is, the BMS according to the present disclosure may include the battery diagnosis apparatus 100 described above. In this configuration, at least some of components of the battery diagnosis apparatus 100 may be implemented by supplementing or adding functions of the components included in a conventional BMS. For example, the data obtaining unit 110, the control unit 120 and the storage unit 130 of the battery diagnosis apparatus 100 may be implemented as components of the BMS.

In one embodiment, the battery diagnosis apparatus 100 may control charging and/or discharging of the battery based on the diagnosis results of the battery. Specifically, the control unit 120 may control charging and/or discharging of the battery so that charging and/or discharging may be optimized for the battery by utilizing the diagnosis results.

In another embodiment, the battery diagnosis apparatus 100 may change various state conditions set for the battery based on the diagnosis results of the battery to prevent further degradation of the battery. For example, the control unit 120 may set at least one of the charging upper limit SOC, the charging upper limit voltage, the charging upper limit C-rate, the discharging lower limit SOC, the discharging lower limit voltage, the discharging upper limit C-rate, and the upper limit temperature of the battery. In the above, the state conditions that can be set by the battery diagnosis apparatus 100 are listed for convenience of explanation, but it should be noted that any state condition that can be set using the diagnosis results of the battery to delay degradation of the battery may be applied without limitation.

In addition, the battery diagnosis apparatus 100 according to the present disclosure may be equipped in a battery pack. That is, the battery pack according to the present disclosure may include the above-described battery diagnosis apparatus 100 and at least one battery cell. In addition, the battery pack may further include electrical components (relays, fuses, etc.) and a case, etc.

FIG. 6 is a drawing schematically illustrating a battery pack 10 according to another embodiment of the present disclosure.

The battery group 11 may include a plurality of battery cells electrically connected in series and/or parallel. For example, the plurality of battery cells may be directly provided in a battery pack 10. In another example, the plurality of battery cells may be included in a battery bank and/or a battery module, and the battery bank and/or the battery module may be included in a battery pack 10.

The positive electrode terminal of the battery group 11 may be connected to the positive electrode terminal P+ of the battery pack 10, and the negative electrode terminal of the battery group 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery group 11 through the first sensing line SL1, and to the negative electrode terminal of the battery group 11 through the second sensing line SL2. The measuring unit 12 may measure the voltage of the battery group 11 based on the voltage measured at each of the first sensing line SL1 and the second sensing line SL2.

In addition, the measuring unit 12 may be connected to the current measurement unit A via the third sensing line SL3. For example, the current measurement unit A may be a current meter or shunt resistor capable of measuring the charge current and discharge current of the battery group 11. The measuring unit 12 may measure the charge current of the battery group 11 via the third sensing line SL3 and calculate the charge amount. In addition, the measuring unit 12 may measure the discharge current of the battery group 11 via the third sensing line SL3 and calculate the discharge amount.

The data obtaining unit 110 may receive battery information measured by the measuring unit and transmit the received battery information to the control unit 120.

The control unit 120 may be connected to communicate with an external device 20. Specifically, the external device 20 is a device that may provide driving information of a vehicle including the battery pack 10 to the control unit 120. For example, the external device 20 is not particularly limited as long as it is a device capable of transmitting driving information to the control unit 120 such as an ECU (electronic control unit) of the vehicle or a user terminal.

The control unit 120 may diagnose the state of the battery pack 10 based on the battery information received from the data obtaining unit 110 and the driving information received from the external device 20.

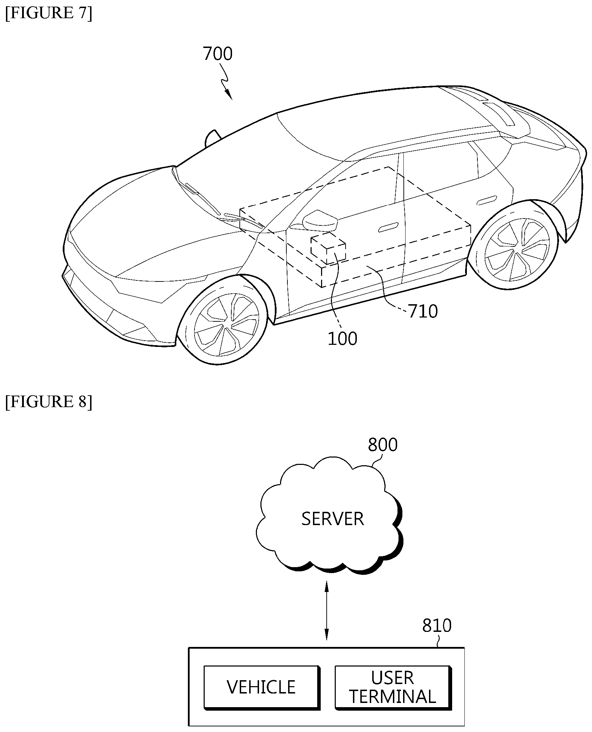

FIG. 7 is a drawing schematically illustrating a vehicle 700 according to still another embodiment of the present disclosure.

Referring to FIG. 7, the battery pack 710 according to an embodiment of the present disclosure may be included in the vehicle 700 such as an electric vehicle (EV) or a hybrid vehicle (HV). Additionally, the battery pack 710 may drive the vehicle 700 by supplying power to the motor through an inverter provided in the vehicle 700. Here, the battery pack 710 may include the battery diagnosis apparatus 100. That is, the battery diagnosis apparatus 100 may be included in the vehicle 700. In this case, the battery diagnosis apparatus 100 may be an on-board device included in the vehicle 700.

FIG. 8 is a drawing schematically illustrating a server 800 according to still another embodiment of the present disclosure.

The server 800 according to still another embodiment of the present disclosure may include the battery diagnosis apparatus 100 according to an embodiment of the present disclosure.

Specifically, the server 800 may be connected to communicate with devices via wired and/or wireless means. For example, in the embodiment of FIG. 8, the server 800 may be connected to communicate with the information providing devices 810, such as vehicles and/or user terminals. Here, the server 800 may be connected without limitation to any device capable of transmitting battery information and driving information.

The server 800 may receive battery information and driving information from the information providing device 810, and diagnose the state of the battery based on the received battery information and driving information. In addition, the server 800 may provide the diagnosis result to the corresponding information providing device 810. In other words, the information providing device 810 may receive the battery state diagnosis result from the server 800.

In addition, the server 800 may store data regarding the diagnosed state of the battery. Also, authorized users may access the server 800 and refer to data regarding the state of the battery.

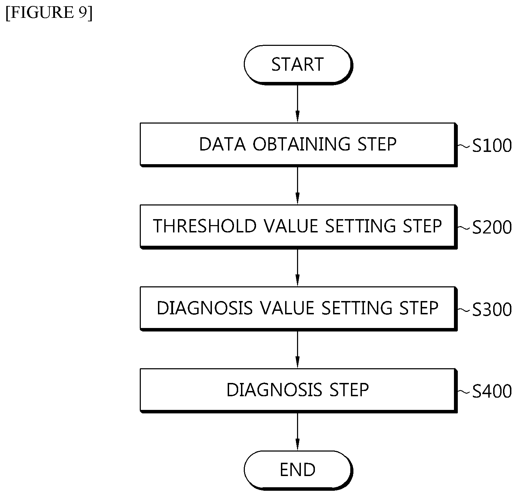

FIG. 9 is a drawing schematically illustrating a battery diagnosis method according to still another embodiment of the present disclosure.

Referring to FIG. 9, the battery diagnosis method may include a data obtaining step (S100), a threshold value setting step (S200), a diagnosis value setting step (S300), and a diagnosis step (S400).

Preferably, each step of the battery diagnosis method may be performed by the battery diagnosis apparatus 100. Hereinafter, for convenience of explanation, the content overlapping with the previously described content will be briefly described or omitted.

The data obtaining step (S100) is a step of obtaining diagnosis data including at least one of battery information of a target battery and driving information of a vehicle including the target battery for a predetermined period from a diagnosis reference time point, and may be performed by the data obtaining unit 110.

For example, the data obtaining unit 110 may obtain battery information by directly measuring the voltage and current of the battery. As another example, the data obtaining unit 110 may also obtain battery information by receiving battery information from an external source that is connected for communication.

In addition, the data obtaining unit 110 may obtain driving information regarding the speed of a vehicle including a battery from an external source. For example, the data obtaining unit 110 may obtain driving information regarding the temporal speed measured while the vehicle is being driven for a predetermined period.

The threshold value setting step (S200) is a step of setting a threshold value based on reference data and a preset model corresponding to the predetermined period, and may be performed by the control unit 120.

For example, the control unit 120 may set data corresponding to the predetermined period among a plurality of preset data as reference data and calculate an error ratio of the reference data using a model. In addition, the control unit 120 may calculate the combined error based on the calculated error ratio and set the calculated combined error as a threshold value.

The diagnosis value setting step (S300) is a step for calculating a diagnosis value based on the diagnosis data and a model, and may be performed by the control unit 120.

For example, the control unit 120 may calculate the error ratio of the diagnosis data using a model. Then, the control unit 120 may calculate the combined error based on the calculated error ratio and set the calculated combined error as a diagnosis value.

The diagnosis step (S400) is a step for diagnosing the state of the target battery based on the threshold value and the diagnosis value, and may be performed by the control unit 120.

Specifically, the control unit 120 may be configured to diagnose the state of the target battery at a time point after a predetermined period from the diagnosis reference time point based on the threshold value and the diagnosis value. For example, if the diagnosis value is less than the threshold value, the control unit 120 may diagnose the state of the battery at a time point after a predetermined period from the diagnosis reference time point as a normal state. As another example, if the diagnosis value is greater than or equal to the threshold value, the control unit 120 may diagnose the state of the battery as an abnormal state.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

Another embodiment of the present disclosure may provide a computer-readable storage medium on which a program for performing the various embodiments described above on a computer is recorded.

The program may be implemented as hardware components, software components, and/or a combination of hardware components and software components. The program may be executed by any system capable of executing computer-readable instructions.

Software may include computer programs, codes, instructions, or a combination thereof, which may configure a processing device to perform a desired operation or may independently or collectively command a processing device.

The software may be implemented as a computer program including instructions stored on a computer-readable storage medium. Examples of the computer-readable storage medium include magnetic storage media (e.g., read-only memory (ROM), random-access memory (RAM), floppy disks, hard disks, etc.) and optical reading media (e.g., CD-ROM, DVD: Digital Versatile Disc). The computer-readable storage medium may be distributed across network-connected computer systems so that the computer-readable codes may be stored and executed in a distributed manner. The storage medium may be readable by a computer, stored in a memory, and executed by a processor.

A computer-readable storage medium may be provided in the form of a non-transitory storage medium. Here, the term 'non-transitory storage medium' simply means that it is a tangible device and does not contain signals (e.g., electromagnetic waves), and this term does not distinguish between cases where data is stored semi-permanently on the storage medium and cases where data is stored temporarily. For example, the 'non-transitory storage medium' may include a buffer in which data is temporarily stored.

Additionally, the program may be provided as part of a computer program product. The computer program product may be traded between sellers and buyers as a commodity.

A computer program product may include a software program, and a computer-readable storage medium storing the software program. For example, the computer program product may include a product in the form of a software program (e.g., a downloadable application) distributed electronically by a manufacturer of an electronic device or through an electronic market. For electronic distribution, at least a portion of the software program may be stored on a storage medium or temporarily generated. In this case, the storage medium may be a storage medium of a server of a manufacturer of an electronic device, a server of an electronic market, or a relay server that temporarily stores the software program.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### [Explanation of symbols]

10: battery pack
11: battery group
12: measuring unit
20: external device
100: battery diagnosis apparatus
110: data obtaining unit
120: control unit
130: storage unit
700: vehicle
710: battery pack
800: server
810: information providing device

## Claims

1. A battery diagnosis apparatus, comprising:
a data obtaining unit configured to obtain diagnosis data including at least one of battery information of a target battery and driving information of a vehicle including the target battery for a predetermined period from a diagnosis reference time point; and
a control unit configured to set a threshold value based on reference data corresponding to the predetermined period and a preset model, calculate a diagnosis value based on the diagnosis data and the model, and diagnose a state of the target battery based on the threshold value and the diagnosis value.

2. The battery diagnosis apparatus according to claim 1,
wherein the control unit is configured to diagnose the state of the target battery at a time point after the predetermined period from the diagnosis reference time point, based on the threshold value and the diagnosis value.

3. The battery diagnosis apparatus according to claim 2,
wherein the control unit is configured to compare the threshold value with the diagnosis value and diagnose the state of the target battery based on the comparison result.

4. The battery diagnosis apparatus according to claim 1,
wherein the control unit is configured to calculate an error ratio of the reference data using the model, calculate a combined error based on the calculated error ratio, and set the calculated combined error as the threshold value.

5. The battery diagnosis apparatus according to claim 1,
wherein the reference data is provided in plurality, and
wherein the control unit is configured to input a plurality of reference data into the model to calculate a combined error, and set the calculated combined error as the threshold value.

6. The battery diagnosis apparatus according to claim 5,
wherein the control unit is configured to calculate an average error rate of the plurality of reference data using the model and calculate the combined error based on the calculated average error rate.

7. The battery diagnosis apparatus according to claim 1,
wherein the control unit is configured to calculate an error ratio of the diagnosis data using the model, calculate a combined error based on the calculated error ratio, and set the calculated combined error as the diagnosis value.

8. The battery diagnosis apparatus according to claim 1,
wherein the control unit is configured to set data corresponding to the predetermined period among a plurality of preset data as the reference data.

9. The battery diagnosis apparatus according to claim 8,
wherein the control unit is configured to determine data corresponding to a diagnosis item of the target battery among the plurality of data and set the reference data among the determined data.

10. The battery diagnosis apparatus according to claim 1,
wherein the model is configured as a model based on a recurrent neural network (RNN).

11. A battery pack, comprising the battery diagnosis apparatus according to any one of claims 1 to 10.

12. A vehicle, comprising the battery diagnosis apparatus according to any one of claims 1 to 10.

13. A server, comprising the battery diagnosis apparatus according to any one of claims 1 to 10.

14. A battery diagnosis method, comprising:
a data obtaining step of obtaining diagnosis data including at least one of battery information of a target battery and driving information of a vehicle including the target battery for a predetermined period from a diagnosis reference time point;
a threshold value setting step of setting a threshold value based on reference data corresponding to the predetermined period and a preset model;
a diagnosis value setting step of calculating a diagnosis value based on the diagnosis data and the model; and
a diagnosis step of diagnosing a state of the target battery based on the threshold value and the diagnosis value.

15. A computer-readable recording medium storing a computer program for executing a battery diagnosis method, which includes:
a data obtaining step of obtaining diagnosis data including at least one of battery information of a target battery and driving information of a vehicle including the target battery for a predetermined period from a diagnosis reference time point;
a threshold value setting step of setting a threshold value based on reference data corresponding to the predetermined period and a preset model;
a diagnosis value setting step of calculating a diagnosis value based on the diagnosis data and the model; and
a diagnosis step of diagnosing a state of the target battery based on the threshold value and the diagnosis value.
